Europäisches Patentamt

European Patent Office

Office européen des brevets

(19)

(11) Publication number: 0 343 899
A2

# EUROPEAN PATENT APPLICATION

(12)

(21) Application number: 89305155.7

(22) Date of filing: 22.05.89

(51) Int. Cl.4: H03K 5/156

(30) Priority: 23.05.88 JP 126898/88

(43) Date of publication of application:
29.11.89 Bulletin 89/48

(84) Designated Contracting States:
AT BE CH DE ES FR GB GR IT LI LU NL SE

(71) Applicant: ADVANCED MICRO DEVICES, INC.
901 Thompson Place P.O. Box 3453
Sunnyvale, CA 94088(US)

(72) Inventor: Itoh, Tatsuo
11-53 Hachiman-cho 2 chome
Higashikurume-shi Tokyo(JP)

(74) Representative: Wright, Hugh Ronald et al
Brookes & Martin 52/54 High Holborn
London WC1V 6SE(GB)

(54) Circuit for generating pulses having controlled duty cycle.

(57) A circuit for generating a train of pulses having a predetermined controlled duty cycle in response to a train of input pulses, comprising:

means responsibe to said input pulses for generating a ramp signal having a ramp portion formed as a function of the repetition of said input pulses,

means coupled to said ramp signal generating means for threshold detecting said ramp portion of said ramp signal at a predetermined threshold level,

means coupled from the output of said threshold level detecting means to the input of said threshold detecting means for integrating and feeding back the output of said threshold detecting means to the input of said threshold detecting means, and

reference voltage source means coupled to said integrating and feeding back means and said threshold detecting means for providing a reference voltage for determining a threshold detection level of said threshold detecting means.

## Circuit for Generating Pulses Having Controlled Duty Cycle

The present invention generally relates to a pulse generating circuit and more specifically relates to a circuit for generating a train of pulses having a controlled duty cycle in response to a train of pulses having any duty cycle.

Semiconductor chips for microcomputers, microprocessors or the like are operated as a function of a train of clock pulses. For example, a semiconductor chip for a microcomputer currently available in market as referred to as "80286" requires a train of clock pulses of as high as 32MHz having a specified tolerance range of the duty cycle of 45 to 55% and such requirement of a tolerance range is strict particularly in case of a semiconductor chip of a high grade. Nevertheless, a crystal oscillator currently available in market for such purpose typically has merely a specified range of the duty cycle of 40 to 60%. Employment of such crystal oscillator having a larger range of the duty cycle of 40 to 60% to a semiconductor chip requiring clock pulses having a specified smaller tolerance range of the duty cycle of 45 to 55% could cause malfunction.

Generally it is difficult to convert a train of original pulses having a given pulse repetition frequency and a given or changeable duty cycle to another train of new pulses having the same pulse repetition frequency and a precisely controlled predetermined duty cycle. One possible approach to that end is that a train of original pulses having a given pulse repitition frequency and a given or changeable duty cycle is converted to a train of pulses of a higher frequency by the use of a monostable multivibrator or a phase locked loop and then frequency division is made of the train of the new pulses to provide a train of pulses of the same frequency and of a predetermined duty cycle. However, employment of a monostable multivibrator involves a problem that the duty cycle of the converted train of pulses is influenced by a change in the pulse repetition frequency of the input pulses and thus by a change of the period of the input pulses. On the other hand, although employment of a phase locked loop can eliminate such problem, another disadvantage is involved that a voltage controlled oscillator, a frequency divider, a phase comparator and the like are necessary, with the result that a circuit is complicated and expensive.

We will describe a pulse generating circuit of a less complicated structure and which is less expensive for generating a train of pulses of a controlled duty cycle in response to a train of pulses of any different duty cycle.

We will describe a pulse generating circuit for generating a train of pulses of a controlled predetermined duty cycle in response to a train of pulses of any different duty cycle irrespective of a change in the pulse repitition frequency of the input pulses.

Briefly described, the present invention provides a circuit for generating a train of pulses having a predetermined controlled duty cycle in response to a train of input pulses, comprising: means responsive to said input pulses for generating a ramp signal having a ramp portion formed as a function of the repetition of said input pulses, means coupled to said ramp signal generating means for threshold detecting said ramp portion of said ramp signal at a predetermined threshold level, means coupled from the output of said threshold detecting means to the input of said threshold detecting means for integrating and feeding back the output of said threshold detecting means to the input of said threshold detecting means, and reference voltage source means coupled to said integrating and feeding means and said threshold detecting means for providing a reference voltage for determining a threshold detection level of said threshold detecting means.

These objects and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a block diagram showing the principle of the inventive pulse generating circuit;

Fig. 2 is a schematic diagram of one embodiment of the inventive pulse generating circuit;

Fig. 3 is a graph showing the waveforms of the signals at various portions in the circuit shown in Fig. 2;

Fig. 4 is a schematic diagram of another embodiment of the inventive pulse generating circuit;

Fig. 5 is a graph showing the waveforms of the signals at various portions of the circuit shown in Fig. 4; and

Fig. 6 is a schematic diagram of a further embodiment of the inventive pulse generating circuit.

DESCRIPTION OF THE PREFERRED EMBODIMENTS

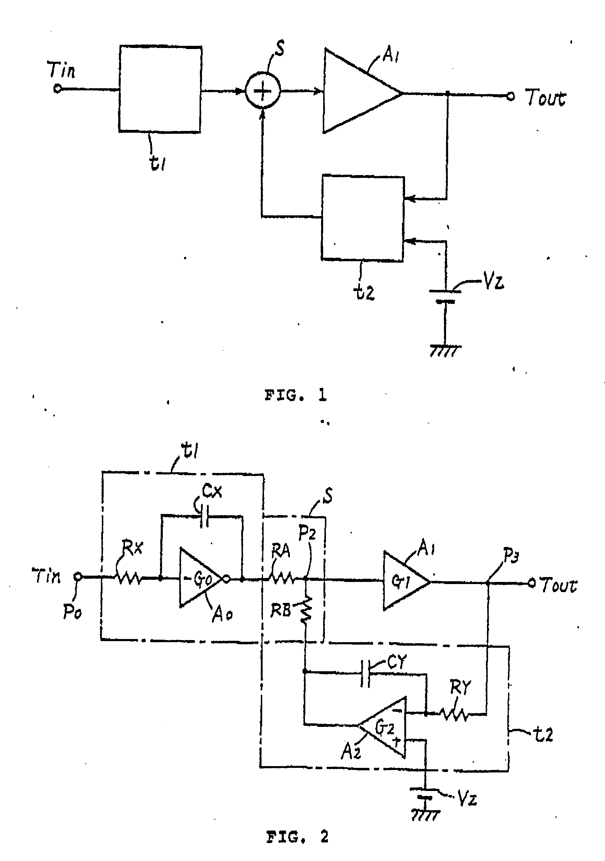

Fig. 1 is a block diagram showing the principle of the inventive pulse generating circuit. The pulse generating circuit shown in Fig. 1 comprises an input terminal Tin for receiving a train of input pulses of a given pulse reptetion frequency and of a given duty cycle which may be changeable, a ramp signal generating circuit t1 coupled to the input terminal Tin and responsive to the input pulses for generating a ramp signal having a ramp portion formed as a function of the repetition of the pulses with a time constant shorter than the pulse repetition period, a summing circuit S coupled to receive at one input the output from the ramp signal generating circuit t1 and to receive at the other input an output from an integrating and feeding back circuit t2 to be described subsequently, a threshold detecting circuit A1 having an amplifying function coupled to the summing circuit S, an output terminal Tout coupled to the output from the threshold detecting circuit A1, an integrating and feeding back circuit t2 having an operational amplifier function for amplifying the output from the threshold detecting circuit A1 with respect to and a reference voltage from a reference voltage source $V_z$ for integrating the output from the threshold detecting circuit A1 with respect to a predetermined reference voltage for supplying the integrated output to the other input of the above described summing circuits. The ramp signal generating circuit t1 may comprise an integrating circuit or a differentiating circuit, insofar as the same has a function of generating a ramp signal having a ramp portion formed as a function of the repetition of the input pulses.

In operation, the ramp signal generating circuit t1 is responsive to the input pulses to generate a ramp signal having a ramp portion formed as a function of the repetition of the input pulses and the output from the ramp signal generating circuit t1 is threshold detected by the threshold detecting circuit A1 so that the ramp portion of the ramp signal may be threshold detected at a predetermined threshold level and the threshold detected output is amplified to provide a pulse shaped output. The pulse shaped output from the threshold detecting circuit A1 is then amplified with respect to the reference voltage from the reference voltage source $V_z$ and is integrated with a time constant larger than the input pulse repetition period so that the integrated output is fed back to the threshold detecting circuit A1 through the summing circuit S. A direct current component available in the feedback loop including the threshold detecting circuit A1, the integrating and feeding back circuit t2 and the summing circuit S is determined as a function of the reference voltage from the reference voltage source $V_Z$ and hence a threshold level where the output from the summing circuit S is threshold detected is determined accordingly by the reference voltage when the reference voltage source is properly adjusted. On the other hand, the threshold level of the threshold detecting circuit A1 serves to determine the phase of the threshold detection of the ramp portion of the ramp signal. Accordingly, the duty cycle of the output pulses from the threshold detecting circuit A1 is primarily determined by the reference voltage from the reference voltage source $V_Z$.

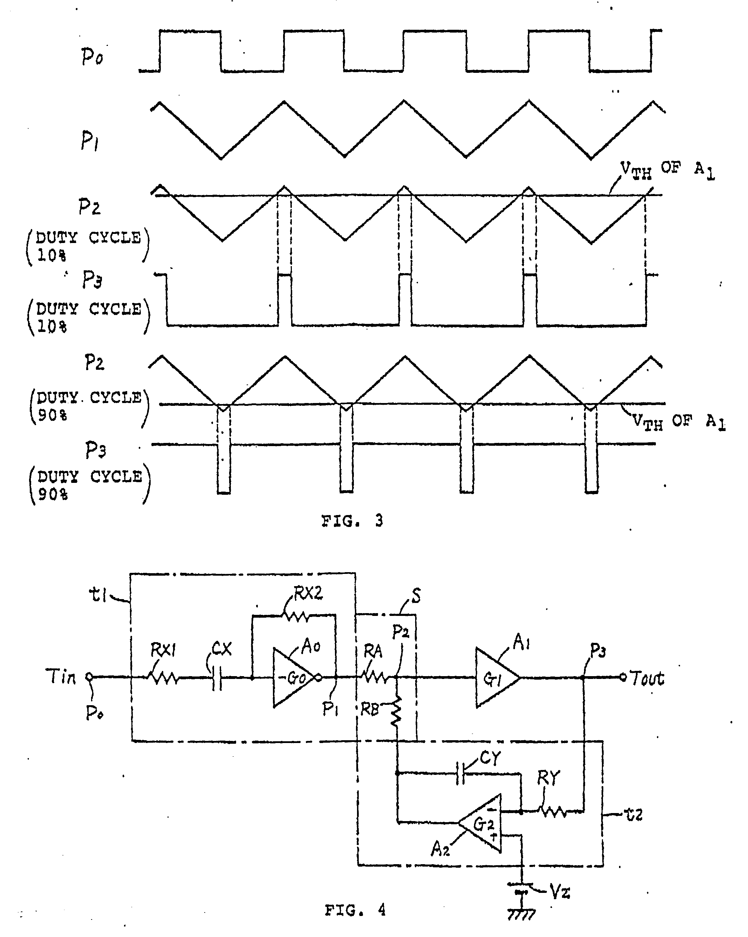

Fig. 2 is a schematic diagram of one embodiment of the inventive pulse generating circuit. The ramp signal generating circuit t1 comprises an input resistor Rx, an amplifier A0 having a gain -G0 and a capacitor Cx coupled between the input and output of the amplifier A0. The summing circuit S comprises a resistor network including a resistor RA and a resistor RB. The integrating and feeding back circuit t2 comprises an operational amplifier A2 having a gain G2 and having an inverting input being connected through a resistor RY to the output of the amplifier A1 and a non-inverting input being connected to the reference voltage source VZ, and a capacitor CX being connected betweens the input and the output of the amplifier A2. The gains -G0, G1 and G2 of the amplifiers A0, A1 and A2, respectively, are selected to have relatively large values. The time constant determined by the resistor RX and the capacitor CX is selected so that the amplifier A0 may serve as an integrating circuit to provide a ramp signal having a ramp portion formed as a function of the repetition of the input pulses. An operation of the pulse generating circuit shown in Fig. 2 will be better understood with reference to Fig. 3, which shows a graph showing the waveforms of signals at various portions in the Fig. 2 circuit. The input pulses P0 from the input terminal Tin are integrated by the amplifier A0 with the time constant RX.CX so that an output P1 of a triangle waveform is obtained from the output of the amplifier A0. While the output 1 is supplied through the resistor RA to the input of the amplifier A1, the output including an integrated value of the output from the amplifier A1 with the time constant RY.CY is supplied through the resistor RB to the input of the amplifier A1. Thus, the output from the amplifier A0 and the output from the amplifier A2 are summed by the summing circuit S including the resistors RA and RB and the summed output is threshold detected by the amplifier A1. Since the time constant RY.CY was selected to be sufficiently large as compared with the repetition period of the input pulses, the output from the amplifier A2 may be considered as a direct current component. As a result, the output of a triangle waveform from the amplifier A0 is biased with the direct current component available from the amplifier A2 through the resistor RB when the output from the amplifier A0 is threshold detected by the amplifier A1.

Assuming that the output voltage of the high level from the amplifier A1 is $V_{OH}$, the period of high level output voltage $V_{OH}$ is $t_{OH}$, and the output voltage of the low level from the amplifier A1 is $V_{OL}$, and the period of the low level output voltage $V_{OL}$ is $t_{OL}$, then the following equation is obtained with respect to the reference voltage $V_Z$ applied to the non-inverting input of the amplifier A2.

$$(V_{OH} \times t_{OH} + (V_{OL} \times t_{OL}) = V_Z \qquad (1)$$
$$t_{OH} = t_{OL} = T \qquad (2)$$

Assuming that the amplifier A1 is implemented with complimentary MOS devices, the values $V_{OH}$ and the $V_{OL}$ are known and stable. As a result, the duty cycle of the output from the amplifier A1 is determined as a function of reference voltage $VZ$ irrespective of the repetition period T of the input pulses.

It is pointed out that the former waveforms P2 and P3 in Fig. 3 are of the triangle waves from the amplifier A0 and the output pulses from the amplifier A1 in case that the duty cycle was adjusted to be 10% and the latter waveforms P2 and P3 in Fig. 3 are of the triangle waves from the amplifier A0 and the output pulses from the amplifier A1 in case that the duty cycle was adjusted to be 90%.

Assuming that the gain G2 of the amplifier A2 is sufficiently large and an error of the differential inputs is stable, a fluctuation of the threshold voltage VTH and a fluctuation of the delay time of the amplifiers A0 and A1 for a longer repetition period can be neglected by means of the integrating circuit including the amplifier A2 and the time constant CY.RY. Furthermore, since the magnitude of the repetition period T of the output pulses influences upon only the amplitude of the triangle wave of the output from the amplifier A2, no influence is caused upon the duty cycle insofar as the gain G1 of the amplifier A1 is sufficiently large.

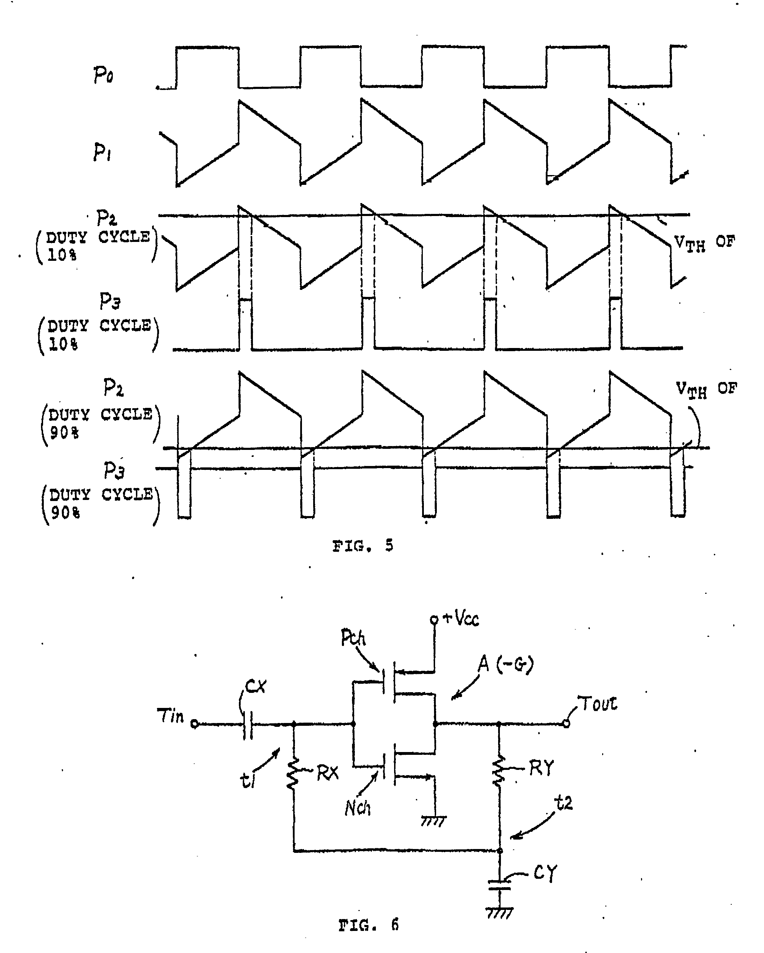

Fig. 4 is a schematic diagram of another embodiment of the inventive pulse generating circuit and Fig. 5 is a graph showing the waveforms of the signals at various portions of the circuit shown in Fig. 4. In comparison of the embodiment shown in Fig. 2, the embodiment shown in Fig. 4 employs the ramp signal generating circuit comprising a differentiating circuit implemented with an amplifier A0 and the capacitor CX and the resistor RX2, while the remaining portions thereof are substantially the same as those shown in Fig. 2.

Referring to the waveforms shown in Fig. 5, the output from the amplifier A0 is not of a triangle waveform but is of serrated waveform which is typically produced in case of differentiation. In spite of a difference in waveforms, however, substantially the same operation as described in conjunction with Fig. 3 occurs in case of the Fig. 4 embodiment as well, as is understood with reference to the waveforms shown in Fig. 5.

Fig. 6 is a schematic diagram of a further embodiment of the inventive pulse generating circuit. In case of the Fig. 6 embodiment, the ramp signal generating circuit t1 is implemented in the form of a differentiating circuit implemented with a capacitor CX and a resistor RX, the integrating and feeding back circuit t2 is implemented with a resistor RY and a capacitor CY, the junction thereof being connected through the resistor RX to the input of the threshold detecting circuit implemented with an amplifier A including a P-channel MOS transistor Pch and an N-channel transistor Nch. The amplifier A is adapted to have a sufficiently large gain -G and a well stabilized threshold level for threshold detection and a sufficiently large direct current input resistance as compared with the resistance RY and a sufficiently small output resistance as compared with the resistant RY. Such amplifier may comprise a CMOS type logic inverter/amplifier.

Similarly to the foregoing, the following equation is obtained among a threshold voltage inherently had by the amplifier A1, the voltage $V_{OH}$ of the high level of the output, the period $t_{OH}$ of the high level, the voltage $V_{OL}$ of the low level of the output and the period $t_{OL}$ of the low level:

$$(V_{OH} \times t_{OH}) + (V_{OL} \times t_{OL}) \fallingdotseq V_{TH} \qquad (3)$$
$$t_{OH} = t_{OL} = T \qquad (4)$$

Usually, a CMOS integrated circuit is designed to have relations $V_{TH} = 1/2\ Vcc$, and $VOL = 0V$. Therefore, if and when a commercially available CMOS logic inverter/amplifier is employed as the amplifer A, the output pulses of the duty cycle of 50% can be obtained irrespective of the repetition period and the duty cycle of the input pulses. However, since a direct current gain the integrating and feeding back circuit of this embodiment is unity, it is impossible to fully eliminate an error of the duty cycle of the input. If and when the output pulses of any other duty cycle is desired, the threshold level $V_{TH}$ of the inverter/amplifer need be changed by properly designing the patterns of the CMOS integrated circuits.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A circuit for generating a train of pulses having a predetermined controlled duty cycle in response to a train of input pulses, comprising: means responsive to said input pulses for generating a ramp signal having a ramp portion formed as a function of the repetition of said input pulses, means coupled to said ramp signal generating means for threshold detecting said ramp portion of said ramp signal at a predetermined threshold level, means coupled from the output of said threshold detecting means to the input of said threshold detecting means for integrating and feeding back the output of said threshold detecting means to the input of said threshold detecting means, and reference voltage source means coupled to said integrating and feeding back means and said threshold detecting means for providing a reference voltage for determining a threshold detection level of said threshold detecting means.

2. A pulse generating circuit in accordance with Claim 1, wherein said ramp signal generating means comprises means responsive to the input pulses for integrating said input pulses for providing a ramp signal having a ramp portion formed as a result of integration of said input pulses.

3. A pulse generating circuit in accordance with Claim 1, wherein said ramp signal generating means comprises means responsive to the input pulses for differentiating said input pulses for providing a ramp signal having a ramp portion formed as a result of differentiation of said input pulses.

4. A circuit for generating a train of pulses in accordance with Claim 1, which further comprises summing means for summing the output from said ramp signal generating means and the output from said integrating and feeding back means.

5. A circuit for generating pulses in accordance with Claim 1, wherein said integrating and feeding back means comprises amplifying means for amplifying the output from said threshold detecting means, and integrating circuit means for integrating the output from said amplifying means.

6. A circuit for generating pulses in accordance with Claim 5, wherein said amplifying means comprises operational amplifying means adapted to receive the output from said threshold detecting means the the reference voltage from said reference voltage means.

7. A circuit for generating pulses in accordance with Claim 1, wherein said threshold detecting means comprises an amplifier including field effect devices having a predetermined threshold voltage, and said reference voltage source means comprises means for determining a threshold detection level based on said predetermined threshold voltage of said field effect devices.

FIG. 1

FIG. 2

19783

FIG. 3

FIG. 4

FIG. 5

FIG. 6